(19) Europäisches Patentamt
European Patent Office
Office européen des brevets

(11)  **EP 3 134 923 B1**

(12)  **FASCICULE DE BREVET EUROPEEN**

(45) Date de publication et mention
de la délivrance du brevet:
**24.01.2018  Bulletin 2018/04**

(21) Numéro de dépôt: **15711233.5**

(22) Date de dépôt: **23.03.2015**

(51) Int Cl.:
*H01L 31/0747* (2012.01)        *H01L 31/18* (2006.01)
*H01L 31/20* (2006.01)

(86) Numéro de dépôt international:
**PCT/EP2015/056149**

(87) Numéro de publication internationale:
**WO 2015/161966 (29.10.2015 Gazette 2015/43)**

(54)  **PROCÉDÉ ET ÉQUIPEMENT DE TRAITEMENT D'UN PRÉCURSEUR D'UNE CELLULE PHOTOVOLTAÏQUE A HÉTÉROJONCTION ET PROCÉDÉ ASSOCIÉ DE FABRICATION D'UNE CELLULE PHOTOVOLTAÏQUE**

VERFAHREN UND VORRICHTUNG ZUR BEHANDLUNG EINES VORLÄUFERS EINER HETEROÜBERGANGS-PHOTOVOLTAIKZELLE UND ZUGEHÖRIGES VERFAHREN ZUR HERSTELLUNG EINER PHOTOVOLTAIKZELLE

METHOD AND DEVICE FOR TREATING A PRECURSOR OF A HETEROJUNCTION PHOTOVOLTAIC CELL AND ASSOCIATED METHOD FOR PRODUCING A PHOTOVOLTAIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.04.2014  FR 1453743**

(43) Date de publication de la demande:
**01.03.2017  Bulletin 2017/09**

(73) Titulaire: **Commissariat à l'Énergie Atomique et aux Énergies Alternatives
75015 Paris (FR)**

(72) Inventeur: **VARACHE, Renaud
63730 La Sauvetat (FR)**

(74) Mandataire: **Novaimo
ActiTech 8
60 avenue Marie Curie
Archamps Technopole
74166 Saint Julien-en-Genevois Cedex (FR)**

(56) Documents cités:
**FR-A1- 2 977 079**

- **MISHIMA T ET AL: "Development status of high-efficiency HIT solar cells", SOLAR ENERGY MATERIALS AND SOLAR CELLS, ELSEVIER SCIENCE PUBLISHERS, AMSTERDAM, NL, vol. 95, no. 1, 1 janvier 2011 (2011-01-01), pages 18-21, XP027476522, ISSN: 0927-0248, DOI: 10.1016/J.SOLMAT.2010.04.030 [extrait le 2010-04-28]**
- **TANAKA M ET AL: "DEVELOPMENT OF NEW A-SI/C-SI HETEROJUNCTION SOLAR CELLS: ACJ-HIT (ARTIFICIALLY CONSTRUCTED JUNCTION-HETEROJUNCTION WITH INTRINSIC THIN-LAYER)", JAPANESE JOURNAL OF APPLIED PHYSICS, JAPAN SOCIETY OF APPLIED PHYSICS, JP, vol. 31, no. 11, PART 01, 1 novembre 1992 (1992-11-01), pages 3518-3522, XP000414728, ISSN: 0021-4922, DOI: 10.1143/JJAP.31.3518**

**Description**

L'invention concerne un procédé de traitement d'un précurseur de cellule photovoltaïque à hétérojonction visant à améliorer le rendement de conversion de cette cellule.

Une cellule photovoltaïque à hétérojonction de silicium associe en général du silicium cristallin et du silicium amorphe. Elle est fabriquée à partir d'une plaquette, ou « wafer » en silicium cristallin (c-Si), sur laquelle, après nettoyage, on dépose une ou plusieurs couche(s) de silicium amorphe (a-Si) sur chacune des faces de la plaquette,. Le silicium amorphe peut être par exemple du silicium amorphe hydrogéné (a-Si :H). Généralement, la couche de silicium cristallin est de type N, alors que la ou les couches de silicium amorphe sont de type P d'un côté, et de type N de l'autre. Toutefois, toute autre combinaison des types N et/ou P est envisageable. Une couche d'un oxyde transparent conducteur électrique (TCO - de l'anglais « *Transparent Conductive Oxide* ») est ensuite déposée sur au moins une face. Plus largement, le TCO peut être remplacé par un matériau conducteur transparent en face avant, et par un matériau conducteur électrique en face arrière (transparent ou non). Enfin, des métallisations sont réalisées pour former des contacts électriques.

La qualité de l'interface entre le silicium amorphe et le silicium cristallin est déterminante pour optimiser les performances de la cellule, notamment son rendement de conversion.

En effet, lors du fonctionnement de la cellule photovoltaïque, la lumière qui est absorbée par le silicium cristallin génère des électrons et des trous permettant de produire de l'électricité. Or, ces électrons et ces trous peuvent recombiner à l'interface entre le silicium cristallin et le silicium amorphe avec des défauts non passivés, typiquement des liaisons de silicium non saturées et/ou des impuretés. Par le terme « interface », on entend désigner le ou les premiers nanomètres de silicium amorphe jouxtant le silicium cristallin au niveau de la zone de séparation entre silicium amorphe et silicium cristallin. La recombinaison à l'interface des électrons et des trous qui ont été générés entraîne la perte de ces électrons et de ces trous, ce qui dégrade le rendement de la cellule. Il convient donc de limiter cette recombinaison d'électrons et de trous en contrôlant les défauts recombinants à l'interface.

Pour améliorer la qualité de l'interface, il est connu de déposer, entre le silicium cristallin et la couche de silicium amorphe dopée, une couche intermédiaire en silicium amorphe intrinsèque. Cette couche de silicium amorphe intrinsèque est initialement de bonne qualité : son niveau de Fermi est proche du milieu du gap et par conséquent sa densité de défauts est quasi-minimale. En effet, selon le modèle dit de « *defect pool* », la densité de défaut dans un matériau semi-conducteur dépend de la position du niveau de Fermi de ce matériau. Typiquement, selon ce modèle, la densité de défauts est minimale lorsque le niveau de Fermi est positionné au milieu, ou sensiblement au milieu, du gap. La couche intrinsèque déposée sur le silicium cristallin a pour but de réduire la densité de défauts à l'interface et donc d'améliorer le rendement de la cellule.

Toutefois, lors de la fabrication de la cellule, lorsque la couche de silicium amorphe dopé P (ou N) est déposée par-dessus la couche de silicium amorphe intrinsèque, cette couche dopée P (ou N) force le niveau de Fermi de la couche intrinsèque à se rapprocher de la bande de valence (ou de la bande de conduction). En définitive, la couche amorphe dopée P (ou N) influence le niveau de Fermi de la couche amorphe intrinsèque. En particulier, sa présence modifie le niveau de Fermi de la couche amorphe intrinsèque et le rapproche du niveau de Fermi de la même couche amorphe mais dopée P (ou N). Or, comme ce dépôt de la couche dopée P (ou N) s'effectue à une température proche d'une température seuil d'équilibration des défauts dans le silicium amorphe, il en résulte une modification de la densité de défauts dans la couche intrinsèque qui tend vers une densité de défauts correspondant au niveau de Fermi modifié.

Il existe des traitements post-déposition (c'est-à-dire après dépôt de la couche de silicium amorphe) visant à améliorer la qualité de l'interface entre silicium amorphe et silicium cristallin.

Ces traitements sont principalement basés sur un recuit en température.

En particulier, le document WO2013/001440 décrit un procédé de traitement post-déposition de recuit en température sous illumination, consistant à chauffer la cellule photovoltaïque à une température comprise entre 20° et 200°C tout en la soumettant à un flux lumineux déterminé. La durée d'un tel traitement est généralement de plusieurs heures, ce qui s'avère difficile à mettre en oeuvre car trop long d'un point de vue industriel.

La présente invention vient améliorer encore la situation.

A cet effet, l'invention concerne un procédé de traitement d'un précurseur d'une cellule photovoltaïque à hétérojonction, le précurseur comportant au moins une couche de silicium cristallin dopé et une couche de matériau semi-conducteur amorphe dopé, caractérisé en ce qu'il comprend les étapes suivantes :

- placer le précurseur de cellule en sandwich entre une plaque conductrice mise à la masse et une plaque en matériau isolant recouverte d'une couche conductrice ;
- appliquer une tension électrique de changement d'état entre la couche conductrice et la masse, ladite tension électrique de changement d'état étant adaptée pour rapprocher le niveau de Fermi à l'interface entre silicium cristallin et matériau semi-conducteur amorphe du milieu du gap dudit matériau semi-conducteur amorphe, tout en chauffant le précurseur de cellule à une température d'équilibration de défauts ;

- refroidir le précurseur de cellule avant d'interrompre l'application de la tension électrique de changement d'état.

Selon l'invention, le précurseur de cellule est soumis à un chauffage, sous tension électrique. Le précurseur de cellule correspond à un empilement multicouche comportant au moins une couche de silicium cristallin dopée et une couche de matériau semi-conducteur amorphe, laquelle peut être également dopée, micro-dopée ou intrinsèque. Il est de plus destiné à former une cellule photovoltaïque à hétérojonction. En toute hypothèse, une interface, notée INT, entre silicium cristallin et semi-conducteur amorphe est disposée à la séparation entre le silicium cristallin et semi-conducteur amorphe. L'application de la tension électrique de changement d'état aux bornes du précurseur a pour effet de décaler le niveau de Fermi en le rapprochant du milieu du gap, à l'interface INT. Dans ces conditions, l'état d'énergie de l'interface INT est analogue à celui d'un semi-conducteur intrinsèque. Le chauffage apporte alors l'énergie nécessaire pour provoquer une équilibration des défauts dans l'interface INT induite par le niveau de Fermi positionné au milieu du gap ou proche de celui-ci. Il en résulte une diminution de la densité de défauts dans l'interface INT, laquelle tend à se stabiliser à une valeur de densité d'équilibre qui dépend du niveau de Fermi décalé. Cette densité d'équilibre correspond à la densité de défauts d'un semi-conducteur amorphe parfaitement intrinsèque. Le précurseur est ensuite refroidi, avant interruption de l'application de la tension électrique de changement d'état, afin d'éviter une augmentation non souhaitée, a posteriori, de la densité de défauts.

Le procédé de l'invention peut comprendre tout ou partie des caractéristiques additionnelles suivantes :

- la température d'équilibration est supérieure ou égale à une température seuil d'équilibration des défauts au-dessous de laquelle l'énergie apportée est insuffisante pour permettre une modification de la densité de défauts dans le semi-conducteur amorphe ;
- la température d'équilibration est supérieure ou égale à 150°C ;
- la température d'équilibration est inférieure ou égale à une température maximale au-delà de laquelle le semi-conducteur amorphe serait dégradé ;
- la température d'équilibration est inférieure ou égale à une température maximale au-delà de laquelle le semi-conducteur amorphe serait dégradé, notamment modifié structurellement modifié ;
- la température d'équilibration est inférieure ou égale à 300°C ;
- durant l'application de la tension électrique de changement d'état, on chauffe le précurseur de cellule à la température d'équilibration pendant une durée d'équilibration, le couple de température et de durée d'équilibration étant choisi en fonction d'un rendement souhaité, et en ce que, pour déterminer le couple de température et de durée d'équilibration, lors d'une phase de configuration préalable, on se munit d'une pluralité de précurseurs de cellule de test, analogues au précurseur de la cellule à fabriquer et, pour chaque précurseur de test, on met en oeuvre les étapes de placer ledit précurseur de test en sandwich entre un support mis à la masse et une plaque en matériau isolant recouverte d'une couche métallique conductrice, d'appliquer une tension électrique de changement d'état entre la couche métallique conductrice et la masse, tout en chauffant le précurseur de test à une température d'équilibration et de refroidir le précurseur de test avant d'interrompre l'application de la tension électrique de changement d'état, les différents précurseurs de test étant testés pour différents couples respectifs de température et de durée d'équilibration, puis on évalue le rendement de chaque précurseur de test et on sélectionne le couple optimal de température et de durée d'équilibration correspondant au meilleur rendement obtenu ;
- le précurseur est chauffé à la température d'équilibration sous la tension électrique de changement d'état pendant une durée d'équilibration comprise entre 1 et 30 minutes ;
- l'ensemble comportant le précurseur de cellule, la plaque conductrice et la plaque d'isolant recouverte de la couche conductrice est placé dans une enceinte sous atmosphère contrôlée et, pour refroidir le précurseur, on fait circuler un fluide de refroidissement dans l'enceinte ;
- la plaque d'isolant présente une épaisseur supérieure ou égale à 100 nm.

L'invention concerne aussi un procédé de fabrication d'une cellule photovoltaïque à hétérojonction, caractérisé en ce qu'il comprend :

- une étape consistant à se munir d'un précurseur de cellule comportant au moins une couche de silicium cristallin dopé et une couche de matériau semi-conducteur amorphe dopé et
- la mise en oeuvre d'un procédé de traitement tel que précédemment défini, appliqué audit précurseur de cellule équipement de fabrication.

Avantageusement, après refroidissement du précurseur de cellule et interruption de la tension électrique de changement d'état, le procédé de fabrication comprend une étape de dépôt d'au moins une couche en matériau conducteur électrique et une étape de métallisation pour former des contacts électriques.

L'invention concerne encore un équipement de traitement d'un précurseur d'une cellule photovoltaïque à hétérojonction, notamment mis en oeuvre au cours de la fabrication de la cellule, caractérisé en ce qu'il comprend

- une plaque conductrice mise à la masse ;
- une plaque en matériau isolant recouverte d'une couche conductrice, les deux plaques étant agencées pour prendre en sandwich un précurseur de cellule photovoltaïque à traiter, ledit précurseur comportant au moins une couche de silicium cristallin dopé et une couche de matériau semi-conducteur amorphe dopé ;
- un générateur de tension électrique connecté à ladite couche conductrice ;
- un dispositif de chauffage ;
- un dispositif de refroidissement ;
- un module de commande destiné à contrôler le fonctionnement du générateur de tension électrique, du dispositif de chauffage et du dispositif de refroidissement de manière à appliquer une tension électrique de changement d'état entre la couche conductrice et la masse, ladite tension électrique de changement d'état étant adaptée pour rapprocher le niveau de Fermi à l'interface entre silicium cristallin et matériau semi-conducteur amorphe du milieu du gap dudit matériau semi-conducteur amorphe, tout en chauffant le précurseur de cellule à une température d'équilibration de défauts, puis à refroidir le précurseur avant d'interrompre l'application de ladite tension électrique de changement d'état.

L'invention sera mieux comprise à l'aide de la description suivante d'un mode de réalisation particulier du procédé de fabrication d'une cellule photovoltaïque à hétérojonction, en référence aux dessins annexés sur lesquels :

- La figure 1 représente un dispositif de traitement d'un précurseur de cellule pour la fabrication d'une cellule photovoltaïque selon un mode de réalisation particulier de l'invention ;
- La figure 2 représente une vue schématique de la cellule en coupe ;
- La figure 3 représente l'évolution de la température du précurseur de cellule et l'évolution de la tension électrique appliquée durant le traitement du précurseur de cellule ;
- La figure 4 représente l'évolution de la densité de défauts dans du silicium amorphe en fonction de la position du niveau de Fermi dans le silicium amorphe, selon les prédictions du modèle de « defect pool » ;
- La figure 5 représente l'évolution de la tension électrique en circuit ouvert d'une cellule photovoltaïque fabriquée selon le procédé de l'invention, en fonction de la position modifiée du niveau de Fermi durant le traitement ;
- La figure 6 représente un organigramme des étapes du procédé.

Le procédé de l'invention concerne la fabrication d'une cellule photovoltaïque à hétérojonction, référencée 100. Il porte plus particulièrement sur un processus de traitement d'un précurseur de cellule 10 destiné à la fabrication de la cellule 100, qui vise à améliorer les performances de la cellule terminée 100. Ce traitement est mis en oeuvre en cours de fabrication de la cellule 100.

Dans l'exemple particulier décrit ici, la cellule photovoltaïque à hétérojonction 100 est une cellule dite de type N, c'est-à-dire qu'elle comporte une couche centrale 1 en en silicium cristallin dopée type N et sur laquelle et sous laquelle sont disposées respectivement deux couches 2 et 3 en un matériau semi-conducteur amorphe, par exemple en silicium amorphe hydrogéné. La couche centrale 1 est en particulier réalisée à partir d'un substrat, en l'espèce un « wafer » ou plaquette, en silicium cristallin dopé selon le type N. Le matériau la constituant est alors noté (N) c-Si.

Les couches amorphes 2 et 3 pourraient être réalisées en un matériau semi-conducteur autre que le silicium amorphe hydrogéné, notamment en un alliage amorphe semi-conducteur réalisé à partir de silicium et d'un élément tel que le germanium, le carbone, l'oxygène ou autre.

Au moins l'une des deux couches en silicium amorphe 2, 3 est dopée par un dopage de type P ou N. Dans l'exemple particulier de réalisation décrit ici, la couche supérieure 2 (ou « avant ») est dopée par un dopage de type P et la couche inférieure 3 (ou « arrière ») est dopée par un dopage de type N. Les matériaux constituant respectivement la couche supérieure 2 et la couche inférieure 3 sont notés (P)a-Si :H et (N)a-Si :H.

Toute autre combinaison d'empilement de couches de type P et/ou N peut être envisagée dans le cadre de l'invention. La couche inférieure, ou arrière, 3 pourrait également être réalisée en un matériau semi-conducteur intrinsèque. En toute hypothèse, la cellule comprend au moins une couche de silicium cristallin dopée (de type P ou N) supportant une couche de semi-conducteur amorphe, une interface INT étant disposée à la séparation entre silicium cristallin dopé et semi-conducteur amorphe.

Par définition, un matériau semi-conducteur « intrinsèque » est un matériau semi-conducteur non dopé, dont le comportement électrique ne dépend que de sa structure, et non de l'adjonction d'impuretés comme dans le cas d'un dopage. Dans un matériau semi-conducteur intrinsèque, les porteurs de charge ne sont créés que par des défauts cristallins ou par excitation thermique. En outre, le niveau de Fermi est proche du milieu du gap (plus précisément légèrement supérieur au milieu du gap).

La cellule photovoltaïque 100 comprend également ici une couche intermédiaire 4 en matériau semi-conducteur intrinsèque, en l'espèce du silicium amorphe hydrogéné noté (i)a-Si :H, disposée entre la couche centrale 1 et la couche supérieure 2. Cette couche en silicium amorphe intrinsèque est déposée directement sur la couche centrale 1, afin de réduire le nombre de défauts à l'interface INT entre silicium amorphe et silicium cristallin.

On pourrait également envisager de déposer une couche intermédiaire de matériau semi-conducteur amorphe intrinsèque sous la couche centrale 1, entre celle-ci et la couche inférieure 3 de matériau semi-conducteur amorphe.

La ou les couches intermédiaires pourraient être micro-dopées, au lieu d'être intrinsèques.

Par le terme « interface INT », on entend désigner ici une région située à la séparation entre silicium cristallin et silicium amorphe qui contient le ou les premiers nanomètres de silicium amorphe, typiquement les 2 ou 3 premiers nanomètres, jouxtant le silicium cristallin.

Après avoir été déposée sur la couche centrale 1, la couche de silicium amorphe intrinsèque 4 est initialement de bonne qualité : son niveau de Fermi est proche du milieu du gap du silicium amorphe intrinsèque et par conséquent sa densité de défauts est minimale selon les prédictions du modèle de « *defect pool* » (que l'on peut traduire par « modèle de réservoir de défauts »). Pour de plus amples renseignements sur le modèle de « *defect pool* », le lecteur est invité à se reporter par exemple au document « Defect-pool model and the hydrogen density of states in hydrogenated amorphous silicon », M. J. Powell and S. C. Deane, Phys. Rev. B, 53:10121-32, 1996. La couche intrinsèque 4 qui est déposée sur le silicium cristallin a pour but de réduire les défauts à l'interface INT et donc d'améliorer le rendement de la cellule 100.

Toutefois, lorsque la couche 2 de silicium amorphe dopé P est déposée par-dessus la couche 4 de silicium amorphe intrinsèque, cette couche dopée P force le niveau de Fermi de la couche intrinsèque 4, et par conséquent de l'interface INT, à se rapprocher de la bande de valence, comme si la couche intrinsèque 4 était dopée P. Il en résulte une modification du niveau de Fermi dans l'interface INT qui se rapproche du niveau de valence. Or, comme le dépôt de la couche dopée P s'effectue à une température proche ou supérieure à une température seuil d'équilibration des défauts, la densité de défauts dans la couche intrinsèque 4, y compris dans l'interface INT, varie, et plus précisément augmente, jusqu'à une densité de défauts d'équilibre qui dépend du niveau de Fermi modifié.

Chaque couche de silicium amorphe 2 (respectivement 3) est recouverte d'une couche supérieure, ou avant, 5 (respectivement inférieure, ou arrière, 6) d'un matériau transparent conducteur, par exemple un oxyde transparent conducteur électrique, ou TCO (de l'anglais « *Transparent Conductive Oxide* »).

Les épaisseurs des couches peuvent être les suivantes :

- couche centrale 1 comprise en 50 et 200 $\mu$m ;
- couches 2 (silicium amorphe dopé), 3 (silicium amorphe dopé) et 4 (silicium intrinsèque) comprises chacune entre 1 et 40 nm ;
- couches 5 et 6 (matériau conducteur) comprises chacune entre 50 et 300 nm.

Enfin, des contacts électriques supérieurs (ou avant) 7A, 7B sont disposés sur la face libre de la couche supérieure 5 de TCO, dite « face avant » de la cellule 100, et des contacts électriques inférieurs (ou arrière) 8A, 8B sont disposés sur la face libre de la couche inférieure 6 de TCO, dite « face arrière » de la cellule 100.

Notons qu'en face arrière, la couche 6 n'est pas nécessairement transparente. Pour une cellule de type bifacial, la couche 6 a la même fonction qu'en face avant et est, dans ce cas, transparente. Pour une cellule de type mono-facial, ayant une métallisation pleine plaque, la couche 6 assure un meilleur contact sur le silicium amorphe et n'a pas besoin d'être transparente. Ces couches 5 et 6 assurent le transport latéral des charges vers les contacts électriques ou métallisations avant et arrière.

L'invention permet de réduire la densité de défauts dans l'interface INT entre silicium cristallin et silicium amorphe dans la cellule 100 par un traitement thermique sous tension électrique de cette interface INT. Ce traitement est appliqué en cours de fabrication de la cellule 100.

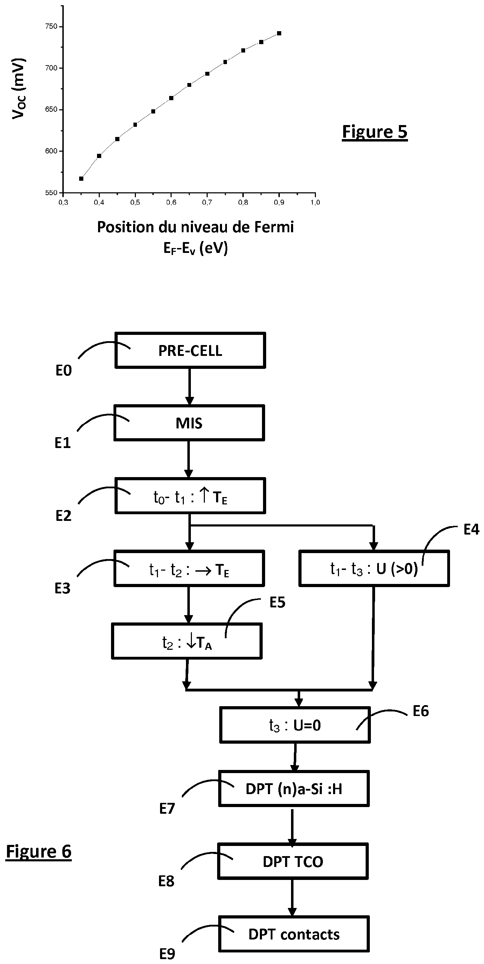

Le procédé de fabrication de la cellule 100, selon un mode de réalisation particulier de l'invention, va maintenant être décrit en référence notamment à la figure 6. Par souci de concision, seules les étapes relatives à l'invention seront détaillées dans la description qui suit.

Lors d'une étape initiale E0, on se munit d'un précurseur de cellule 10 comportant ici l'empilement de la couche centrale 1 de silicium cristallin de type N, de la couche de silicium amorphe intrinsèque 4 et de la couche supérieure 2 de silicium amorphe de type P. Le précurseur de cellule 10 est réalisé de façon connue à partir d'une plaquette ou « wafer » de silicium cristallin de type N sur laquelle la couche de silicium amorphe intrinsèque 4 et la couche supérieure 2 de silicium amorphe de type P sont successivement déposées.

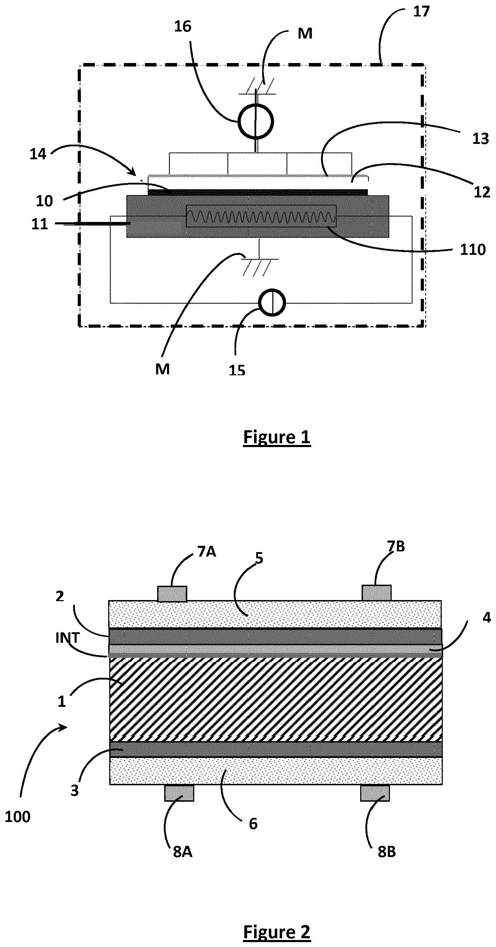

Lors d'une deuxième étape E1, le précurseur de cellule 10 est placé en sandwich, c'est-à-dire intercalé, entre une plaque support conductrice 11 mise à la masse et une plaque 12 en matériau isolant recouverte d'une couche conductrice 13, comme représenté sur la figure 1. Par exemple, la plaque 12 est en mica et la couche conductrice 13 est en métal ou alliage métallique. La plaque support 11 est ici une plaque chauffante, intégrant une résistance de chauffage 110 reliée à un générateur de courant 15. La plaque support chauffante 11 est destinée à chauffer le précurseur de cellule 10.

L'ensemble comportant la couche conductrice 13, l'isolant 12 et le précurseur de cellule 10 forme une structure 14 de type MIS (pour « Métal Isolant Semi-conducteur »), dans laquelle le précurseur de cellule 10 joue le rôle du semi-conducteur de la structure MIS. Cette structure 14 est disposée sur le support 11 qui est relié à une référence de potentiel, en l'espèce à la masse M.

La couche conductrice 13 est reliée à un générateur de tension électrique 16, par l'intermédiaire de contacts électriques, non représentés. Le générateur 16 est destiné à appliquer une tension électrique de changement d'état U1 entre la couche conductrice 13 et la masse M (ou la référence de potentiel à laquelle la plaque support 11 est connectée).

La structure MIS et la plaque support 11 sont placées dans une enceinte 17 sous atmosphère contrôlé, dans laquelle on fait circuler du dihydrogène et/ou du diazote. On pourrait également envisager de faire le vide dans l'enceinte.

En variante, la structure MIS 14 et la plaque support 11 pourraient être placées dans un four destiné à chauffer le précurseur de cellule 10. Dans ce cas, la plaque support 11 ne serait pas chauffante mais serait néanmoins connectée à la masse M.

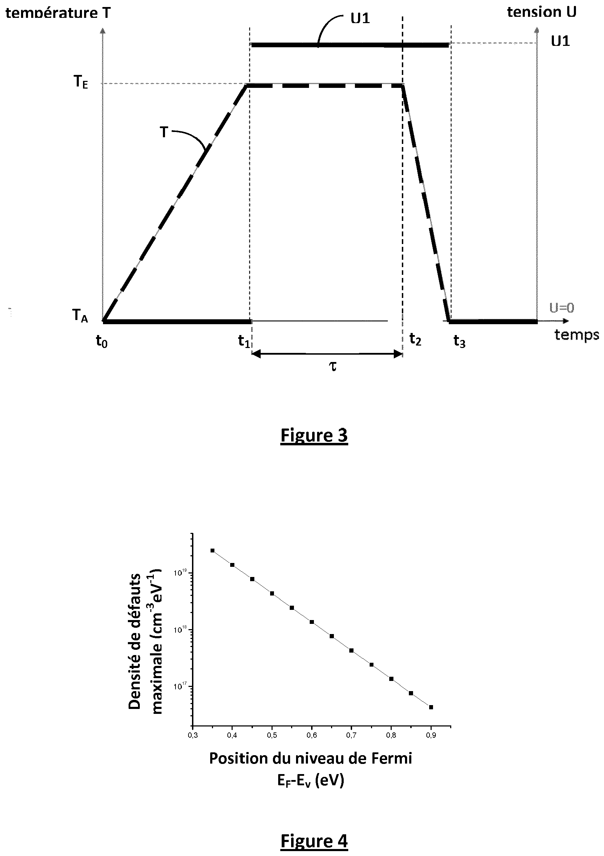

Après réalisation de la structure MIS, lors d'une étape E2, le précurseur de cellule 10 est chauffé au moyen de la plaque chauffante 11 dont la résistance est alimentée en courant par le générateur 15. Sur la figure 3, on a représenté l'évolution de la température T du précurseur 10 par des traits en pointillés. Initialement, la température T du précurseur 10 est égale à la température ambiante $T_A$. Le chauffage fait passer la température T du précurseur 10 de la température ambiante $T_A$ à une température d'équilibration $T_E$. Notons $t_0$ l'instant de début de chauffage et $t_1$ l'instant auquel le précurseur 10 atteint la température $T_E$.

Lors d'une étape E3, le chauffage se poursuit de manière à maintenir la température T du précurseur de cellule 10 à la température d'équilibration $T_E$, jusqu'à un instant $t_2$. Une sonde de température (non représentée) reliée au support métallique 11 permet de contrôler la température T et contrôle le fonctionnement du générateur de courant 15 alimentant la résistance 110 de la plaque chauffante 11.

La température d'équilibration $T_E$ doit être supérieure à une température seuil d'équilibration $T_{TSH}$. Par « température seuil d'équilibration », on entend désigner une température minimale à partir de laquelle les défauts initialement présents dans le silicium amorphe constituant la couche 4 s'équilibrent, l'énergie apportée par le chauffage étant suffisante pour provoquer des réactions chimiques, telles que décrites notamment dans le document « Defect-pool model and the hydrogen density of states in hydrogenated amorphous silicon », M. J. Powell and S. C. Deane, Phys. Rev. B, 53:10121-32, 1996, qui ont pour effet de diminuer la densité de défauts dans le silicium amorphe. La température d'équilibration $T_E$ doit également être inférieure à une température maximale $T_{max}$ au-delà de laquelle le chauffage dégraderait la structure du silicium amorphe et l'interface INT, notamment par cristallisation et/ou par effusion de l'hydrogène. La température d'équilibration $T_E$ peut être comprise entre 150°C et 300°C.

Notons U la tension électrique «aux bornes » de la structure MIS 14, c'est-à-dire entre la couche métallique conductrice 13 et la masse M. Initialement, à l'instant $t_0$, la tension électrique U est nulle (U=0), comme représenté sur la figure 3. Lors d'une étape E4, à partir de l'instant $t_1$, ou peu après cet instant $t_1$, le générateur de tension 16 applique une tension électrique U égale à une tension électrique de changement d'état, notée U1. Il en résulte une tension électrique non nulle «aux bornes» du précurseur de cellule 10 (c'est-à-dire entre la face supérieure libre de la couche 2 de silicium amorphe et la face inférieure libre de la couche 1 de silicium cristallin). La mise sous tension de la structure MIS 14, et par conséquent du précurseur 10, s'effectue sans faire circuler de courant grâce à l'isolant 12 qui l'empêche de circuler. L'épaisseur de l'isolant 12 doit être supérieure à environ 100 nm afin d'éviter tout courant de fuite.

La valeur U1 de la tension électrique de changement d'état appliquée aux bornes du précurseur de cellule 10 est adaptée pour modifier la position du niveau de Fermi dans l'interface INT du précurseur de cellule 10 et le rapprocher du milieu du gap du silicium amorphe. Le « gap » désigne, de façon connue, la bande interdite entre la bande de valence et la bande de conduction du matériau semi-conducteur, en l'espèce le silicium amorphe hydrogéné constituant la couche intermédiaire 4. La tension électrique de changement d'état U1 qu'il convient d'appliquer pour décaler le niveau de Fermi jusqu'au milieu du gap ou à une position proche de celui-ci, dépend aussi de l'épaisseur de l'isolant 12. Plus l'isolant 12 est épais, (l'épaisseur de l'isolant permettant notamment d'assurer un bonne tenue mécanique de la couche 12), plus la tension électrique de changement d'état U1 doit être élevée. Selon l'épaisseur de l'isolant 12, la tension électrique de changement d'état U1 peut ainsi être comprise entre quelques dizaines de Volts et plusieurs milliers de Volts. Pour déterminer la tension électrique U1 à appliquer, on peut choisir une valeur de tension électrique U1 telle que le produit C*U1, où C représenté la capacité électrique de l'isolant de la structure MIS, soit supérieur à $10^{12}$ charges par cm$^2$. Cette valeur de « $10^{12}$ charges par cm$^2$ » correspond en effet à environ la quantité de charges fixe présente dans la couche 2 de silicium amorphe hydrogéné dopée. Or, c'est cette valeur de quantité de charges qu'il faut faire varier pour changer la position du niveau de Fermi dans la couche

Par « proche du milieu du gap », on entend ici signifier que la position décalée du niveau de Fermi, résultant de l'application de la tension électrique de changement d'état U1, notée $E_F$ et exprimée en eV, est telle que :

$$\frac{(E_c - E_v)}{2} - 0,2 \leq E_F - E_v \leq \frac{(E_c - E_v)}{2} + 0,2$$

où

- $E_c$ et $E_v$ désignent respectivement l'état d'énergie de la limite inférieure de la bande de conduction, exprimée en eV, et l'état d'énergie de la limite supérieure de la bande de valence, exprimés en eV, dans le silicium amorphe hydrogéné constituant la couche 4 ;

- $(E_c - E_v)$ correspond à la hauteur du gap entre la bande de valence et la bande de conduction ;
- $E_F - E_v$ désigne l'état d'énergie, exprimé en eV, du niveau de Fermi par rapport à la bande de valence, correspondant à la « position » relative du niveau de Fermi par rapport à la bande de valence (plus précisément par rapport à la limite supérieure de la bande de valence).

Autrement dit, le niveau de Fermi décalé par application de la tension électrique de changement d'état U1 est compris entre le milieu du gap diminué de 0,2 eV et le milieu du gap augmenté de 0,2 eV.

Dans l'exemple particulier de réalisation décrit ici, le gap est de 1,8 eV. Le niveau de Fermi décalé par application de la tension électrique de changement d'état U1 est donc compris entre 0,7 eV et 1,1 eV.

Le signe de la tension électrique de changement d'état U1 à appliquer dépend des dopages relatifs de la couche 1 de silicium cristallin et de la couche de silicium amorphe 2. Il doit être adapté pour rapprocher le niveau de Fermi du milieu du gap à l'interface INT. Par exemple, dans le cas d'une couche 1 en silicium cristallin de type N et d'une couche 2 de silicium amorphe hydrogéné de type P, le pôle positif doit être appliqué du côté de la couche 2. En d'autres termes, la tension électrique de changement d'état (par rapport à la masse) appliquée par le générateur 16 sur la plaque conductrice 13 est positive.

La tension électrique de changement d'état U1 est appliquée aux bornes du précurseur 10 (c'est-à-dire entre la couche conductrice 13 et la masse M), tout en chauffant et en maintenant le précurseur de cellule 10 à la température $T_E$ d'équilibration des défauts, entre l'instant $t_1$ (ou peu après cet instant $t_1$) et l'instant $t_2$. Notons $\tau$, avec $\tau = t_2 - t_1$, la durée d'équilibration des défauts, correspondant à la durée pendant laquelle le précurseur 10 est soumis à la fois à l'application de la tension électrique de changement d'état U1 et au chauffage à la température $T_E$. Cette durée $\tau$ peut être comprise entre 1 minute et 30 minutes, selon la cinétique d'équilibration des défauts.

Pendant la période d'équilibration des défauts de durée $\tau$ (c'est-à-dire entre les instants $t_1$ et $t_2$), sous l'effet de la tension électrique de changement d'état U1, le niveau de Fermi de l'interface INT décalé est proche du milieu du gap du silicium amorphe constituant l'interface INT. Le niveau de Fermi a alors la même position que dans du silicium amorphe intrinsèque. Grâce à l'énergie apportée par le chauffage à la température d'équilibration $T_E$, la densité de défauts dans l'interface INT s'équilibre en fonction du niveau de Fermi décalé (c'est-à-dire proche du milieu du gap). Le niveau de Fermi décalé correspondant au niveau de Fermi du silicium amorphe intrinsèque, la densité d de défauts dans l'interface INT diminue vers une densité de défauts d'équilibre $d_E$ correspondant à la densité de défauts dans le silicium amorphe intrinsèque. Comme précédemment explicité, l'équilibration des défauts s'effectue par des réactions chimiques telles que décrites dans le document « Defect-pool model and the hydrogen density of states in hydrogenated amorphous silicon », M. J. Powell and S. C. Deane, Phys. Rev. B, 53:10121-32, 1996. Ainsi, l'application de la tension électrique de changement d'état U1 aux bornes du précurseur 10 permet de transformer fictivement, en termes d'état d'énergie, l'interface INT en un semi-conducteur intrinsèque.

Sur la figure 4, on a représenté l'évolution de la densité maximale de défauts dans le silicium amorphe constituant la couche 4 contenant l'interface INT, exprimée en $cm^{-3}.eV^{-1}$) en fonction de la position relative du niveau de Fermi par rapport à la bande de valence, autrement dit ($E_F-E_v$), exprimée en eV, selon les prédictions du modèle de « *defect pool* ». Il ressort de la courbe de la figure 4 que la densité de défauts est minimale lorsque le niveau de Fermi est positionné à 0,9eV au-dessus de la bande de valence, soit au milieu du gap dont la hauteur est de 1,8V.

A l'issue de la période d'équilibration des défauts de durée $\tau$, le procédé se poursuit par une étape E5 de refroidissement du précurseur de cellule 10. Cette étape E5 débute à l'instant $t_2$ et se termine à un instant $t_3$ lorsque le précurseur 10 a atteint de nouveau la température ambiante $T_A$. La durée du refroidissement (c'est-à-dire la durée ($t_3-t_2$)) peut être quelconque. De préférence, il peut s'effectuer rapidement, par exemple en moins de 1 minute, en faisant circuler un fluide de refroidissement, par exemple de l'azote $N_2$ à basse température, dans l'enceinte 17.

Après refroidissement du précurseur 10, à l'instant $t_3$ (ou éventuellement à un instant ultérieur), on interrompt l'application de la tension électrique de changement d'état U, la tension électrique aux bornes du précurseur 10 étant ainsi remise à zéro, lors d'une étape E6.

Notons qu'il convient de refroidir le précurseur de cellule 10 avant d'interrompre la tension électrique de changement d'état U1 afin de ne pas provoquer une augmentation a posteriori de la densité de défauts. On pourrait toutefois envisager d'interrompre l'application de la tension électrique de changement d'état avant que la température du précurseur 10 n'atteigne la température ambiante, dès lors que la température du précurseur 10 est inférieure à la température seuil d'équilibration $T_{TSH}$.

Pour que la densité de défauts dans l'interface INT atteigne ou devienne proche de la densité d'équilibre $d_E$ durant la période de chauffage à température $T_E$ sous tension électrique U1, dite «période d'équilibration », il convient de choisir un couple ($T_{E,\tau}$) de température d'équilibration et de durée d'équilibration définissant un budget thermique suffisant à apporter au précurseur de cellule 10 et permettant d'obtenir un rendement souhaité pour la cellule 100 terminée. Pour déterminer le couple ($T_{E,\tau}$) de température et de durée d'équilibration, lors d'une phase de configuration préalable, on se munit d'une pluralité de précurseurs de cellule de test, analogues au précurseur de cellule 10. Pour chaque précurseur de test, on met en oeuvre les étapes de traitement précédemment décrites E0 à E6. Les différents précurseurs de test sont soumis à des traitement pour différents couples respectifs de température et de durée d'équilibration $(T_{Ei}, \tau_i)$. Lors d'une étape ultérieure d'évaluation, on évalue le rendement de chaque précurseur de test, par exemple en mesurant de façon connue la durée de vie des porteurs minoritaires dans le précurseur de cellule test. On sélectionne enfin le couple optimal de température d'équilibration $T_E$ et de durée d'équilibration $\tau$ correspondant au meilleur rendement. En variante, on pourrait tester le rendement de cellules terminées, réalisées à partir des précurseurs de test traités.

Sur la figure 5, on a représenté l'évolution de la tension électrique en circuit ouvert $V_{OC}$, exprimée en mV, de la cellule 100 terminée en fonction de la position du niveau de Fermi relativement à la bande de valence dans l'interface INT du précurseur 10 pendant la période d'équilibration (sous chauffage $T_E$ et sous tension électrique U1). Les valeurs de $V_{OC}$ les plus élevées sont obtenues pour des niveaux de Fermi proches du milieu du gap (le gap étant de 1,8 eV) pendant le chauffage sous tension électrique.

Soulignons que c'est grâce à l'absence de courant à travers le précurseur de cellule 10 qu'il est possible de décaler le niveau de Fermi par application de la tension électrique de changement d'état jusqu'à la position souhaitée proche du milieu du gap.

Après la mise à zéro de la tension électrique U aux bornes du précurseur 10, le procédé se poursuit par une pluralité d'étapes connues de finalisation de la cellule à partir du précurseur 10. Ces étapes comprennent :

- une étape E7 de dépôt de la couche arrière 3 de silicium amorphe dopé ;
- une étape E8 de dépôt des couches 5 et 6 de TCO ;
- une étape E9 de métallisation pour former les contacts 7A, 7B, 8A et 8B.

A l'issue de l'étape E9, on obtient la cellule photovoltaïque terminée 100.

Les étapes de finalisation E7 à E9 peuvent être réalisées après les étapes de traitement E0 à E6 « dans la foulée » (c'est-à-dire sans interrompre le processus de fabrication) ou après interruption du processus de fabrication. Dans le deuxième cas, les étapes E0 à E6, d'une part, et les étapes E7 à E9, d'autre part, pourraient être mises en oeuvre respectivement par deux acteurs différents de la chaîne de fabrication de la cellule 100.

Dans la description qui précède, le précurseur de cellule 10 comprend un empilement de couches comportant une couche de silicium cristallin dopé, une couche intermédiaire de silicium amorphe hydrogéné intrinsèque et une couche supérieure de silicium amorphe hydrogéné dopé. Cet empilement peut être formé en face avant et/ou en face arrière de la cellule 100. Dans une variante, la couche intermédiaire de silicium amorphe pourrait être micro-dopée. Dans une autre variante, la couche supérieure de silicium amorphe hydrogéné dopé est déposée directement sur le silicium cristallin, sans couche intermédiaire intrinsèque ou microdopée.

Afin de traiter également l'interface, notée INT', entre silicium cristallin et silicium amorphe à la séparation entre la couche centrale 1 et la couche inférieure de silicium amorphe 3, on pourrait effectuer des étapes analogues aux étapes de traitement E1 à E6, par chauffage sous tension électrique, avec un précurseur de cellule constitué de l'empilement de couches comportant la couche centrale 1, la couche intermédiaire 4, la couche supérieure 2 et la couche inférieure 3. Dans ce cas, le traitement de l'interface INT et celui de l'interface INT' seraient effectués l'un après l'autre. On pourrait, le cas échéant, effectuer le traitement de ces deux interfaces INT et INT' par chauffage sous tension électrique de façon simultanée si les dopages respectifs des couches 1, 2 et 3 le permettent.

Une couche intermédiaire de silicium amorphe intrinsèque pourrait être interposée entre la couche centrale 1 et la couche inférieure de silicium amorphe dopée.

L'invention concerne aussi un équipement de traitement, destiné à être utilisé au cours de la fabrication d'une cellule photovoltaïque à hétérojonction, comprenant :

- la plaque conductrice 11 mise à la masse ;
- la plaque en matériau isolant 12 recouverte de la couche conductrice 13, les deux plaques 12, 13 étant agencées pour prendre en sandwich un précurseur de cellule photovoltaïque à traiter, par exemple le précurseur 10 ;
- le générateur de tension électrique 16 connecté à la couche conductrice 13 ;
- un dispositif de chauffage, par exemple la résistance 110 alimentée par le générateur de courant 15 et intégrée dans la plaque 11 ;
- un dispositif de refroidissement, par exemple l'enceinte 17 et des moyens pour faire circuler un fluide de refroidissement dans cette l'enceinte 17 ;
- un module de commande (non représenté) destiné à contrôler le fonctionnement du générateur de tension électrique, du dispositif de chauffage et du dispositif de refroidissement de manière à appliquer une tension électrique de changement d'état U1 entre la couche métallique conductrice 13 et la masse, la tension électrique U1 étant adaptée pour rapprocher le niveau de Fermi à l'interface INT entre silicium cristallin et matériau semi-conducteur amorphe du milieu du gap du matériau semi-conducteur amorphe du précurseur, tout en chauffant le précurseur à une température d'équilibration de défauts, puis à refroidir le précurseur avant d'interrompre l'application de ladite tension électrique de changement d'état.

## Revendications

1. Procédé de traitement d'un précurseur d'une cellule photovoltaïque à hétérojonction (100), le précurseur comportant au moins une couche de silicium cristallin dopé (1) et une couche de matériau semi-conducteur amorphe dopé (2, 4), **caractérisé en ce qu'**il comprend les étapes suivantes :

    • placer le précurseur de cellule (10) en sandwich entre une plaque conductrice mise à la masse (11) et une plaque en matériau isolant (12) recouverte d'une couche conductrice (13) ;
    • appliquer une tension électrique de changement d'état (U1) entre la couche conductrice (13) et la masse, ladite tension électrique de changement d'état (U1) étant adaptée pour rapprocher le niveau de Fermi à l'interface (INT) entre silicium cristallin (1) et matériau semi-conducteur amorphe (4) du milieu du gap dudit matériau semi-conducteur amorphe (4), tout en chauffant le précurseur de cellule (10) à une température ($T_E$) d'équilibration de défauts ;
    • refroidir le précurseur de cellule (10) avant d'interrompre l'application de la tension électrique de changement d'état (U1).

2. Procédé de traitement selon la revendication 1, **caractérisé en ce que** la température d'équilibration ($T_E$) est supérieure ou égale à une température seuil ($T_{TSH}$) d'équilibration des défauts au-dessous de laquelle l'énergie apportée est insuffisante pour permettre une modification de la densité de défauts dans le semi-conducteur amorphe (4).

3. Procédé de traitement selon l'une des revendications précédentes, **caractérisé en ce que** la température d'équilibration ($T_E$) est supérieure ou égale à 150°C.

4. Procédé selon l'une des revendications précédentes, **caractérisé en ce que** la température d'équilibration ($T_E$) est inférieure ou égale à une température maximale au-delà de laquelle le semi-conducteur amorphe (4) serait dégradé.

5. Procédé selon l'une des revendications précédentes, **caractérisé en ce que** la température d'équilibration ($T_E$) est inférieure ou égale à 300°C.

6. Procédé selon l'une des revendications précédentes, **caractérisé en ce que**, durant l'application de la tension électrique de changement d'état (U1), on chauffe le précurseur de cellule (10) à la température d'équilibration ($T_E$) pendant une durée d'équilibration ($\tau$), le couple (T,$\tau$) de température et de durée d'équilibration étant choisi en fonction d'un rendement souhaité, et **en ce que**, pour déterminer le couple (T,$\tau$) de température et de durée d'équilibration, lors d'une phase de configuration préalable, on se munit d'une pluralité de précurseurs de cellule de test, analogues au précurseur de la cellule à fabriquer et, pour chaque précurseur de test, on met en oeuvre les étapes de placer ledit précurseur de test en sandwich entre un support mis à la masse et une plaque en matériau isolant recouverte d'une couche métallique conductrice, d'appliquer une tension électrique de changement d'état entre la couche métallique conductrice et la masse, tout en chauffant le précurseur de test à une température d'équilibration et de refroidir le précurseur de test avant d'interrompre l'application de la tension électrique de changement d'état, les différents précurseurs de test étant testés pour différents couples respectifs de température et de durée d'équilibration, puis on évalue le rendement de chaque précurseur de test et on sélectionne le couple optimal de température et de durée d'équilibration correspondant au meilleur rendement obtenu.

7. Procédé selon l'une des revendications, **caractérisé en ce que** le précurseur (10) est chauffé à la température d'équilibration ($T_E$) sous la tension électrique de changement d'état (U1) pendant une durée d'équilibration ($\tau$) comprise entre 1 et 30 minutes.

8. Procédé de traitement selon l'une des revendications précédentes, **caractérisé en ce que** l'ensemble comportant le précurseur de cellule (10), la plaque conductrice (11) et la plaque d'isolant (12) recouverte de la couche conductrice (13) est placé dans une enceinte (17) sous atmosphère contrôlée et, pour refroidir le précurseur (10), on fait circuler un fluide de refroidissement dans l'enceinte (17).

9. Procédé de traitement selon l'une des revendications précédentes, **caractérisé en ce que** la plaque d'isolant (12) présente une épaisseur supérieure ou égale à 100 nm.

10. Procédé de fabrication d'une cellule photovoltaïque à hétérojonction, **caractérisé en ce qu'**il comprend :

    • une étape (E0) consistant à se munir d'un précurseur de cellule (10) comportant au moins une couche de silicium cristallin dopé (1) et une couche de matériau semi-conducteur amorphe dopé (2, 4) et
    • la mise en oeuvre d'un procédé de traitement selon l'une des revendications 1 à 9, appliqué audit précurseur de cellule.

11. Procédé de fabrication selon la revendication précédente, **caractérisé en ce que**, après refroidissement du précurseur de cellule (10) et interruption de la tension électrique de changement d'état (U1), le procédé de fabrication comprend une étape (E8) de dépôt d'au moins une couche en matériau conducteur électrique et une étape de métallisation (E9) pour former des contacts électriques.

12. Equipement de traitement d'un précurseur d'une cellule photovoltaïque à hétérojonction (100), notamment mis en oeuvre au cours de la fabrication de la cellule, **caractérisé en ce qu'**il comprend

   • une plaque conductrice (11) mise à la masse ;
   • une plaque (12) en matériau isolant recouverte d'une couche conductrice (13), les deux plaques (11, 12) étant agencées pour prendre en sandwich un précurseur de cellule photovoltaïque à traiter, ledit précurseur comportant au moins une couche de silicium cristallin dopé et une couche de matériau semi-conducteur amorphe dopé ;
   • un générateur de tension électrique (16) connecté à ladite couche conductrice (13) ;
   • un dispositif de chauffage (110, 15) ;
   • un dispositif de refroidissement (17) ;
   • un module de commande destiné à contrôler le fonctionnement du générateur de tension électrique (16), du dispositif de chauffage (110, 15) et du dispositif de refroidissement (17) de manière à appliquer une tension électrique de changement d'état (U1) entre la couche conductrice (13) et la masse, ladite tension électrique de changement d'état étant adaptée pour rapprocher le niveau de Fermi à l'interface (INT) entre silicium cristallin et matériau semi-conducteur amorphe du milieu du gap dudit matériau semi-conducteur amorphe, tout en chauffant le précurseur de cellule à une température d'équilibration de défauts ($T_E$), puis à refroidir le précurseur avant d'interrompre l'application de ladite tension électrique de changement d'état (U1).

**Patentansprüche**

1. Verfahren zur Behandlung eines Vorläufers einer Heteroübergangs-Photovoltaikzelle (100), wobei der Vorläufer wenigstens eine Schicht aus dotiertem kristallinem Silicium (1) und eine Schicht aus dotiertem amorphem Halbleitermaterial (2, 4) aufweist, **dadurch gekennzeichnet, dass** es die folgenden Schritte umfasst:

   • sandwichartiges Anordnen des Zellvorläufers (10) zwischen einer mit Masse verbundenen leitfähigen Platte (11) und einer Platte aus Isoliermaterial (12), die mit einer leitfähigen Schicht (13) bedeckt ist;
   • Anlegen einer elektrischen Zustandsänderungsspannung (U1) zwischen der leitfähigen Schicht (13) und der Masse, wobei die elektrische Zustandsänderungsspannung (U1) geeignet ist, die Fermi-Energie an der Grenzfläche (INT) zwischen kristallinem Silicium (1) und amorphem Halbleitermaterial (4) an die Mitte der Bandlücke des amorphen Halbleitermaterials (4) anzunähern, bei gleichzeitigem Erwärmen des Zellvorläufers (10) auf eine Äquilibrierungstemperatur ($T_E$) von Defekten;
   • Abkühlen des Zellvorläufers (10), bevor das Anlegen der elektrischen Zustandsänderungsspannung (U1) unterbrochen wird.

2. Verfahren zur Behandlung nach Anspruch 1, **dadurch gekennzeichnet, dass** die Äquilibrierungstemperatur ($T_E$) größer oder gleich einer Schwellenwert-Äquilibrierungstemperatur ($T_{TSH}$) der Defekte ist, unterhalb von der die zugeführte Energie unzureichend ist, um eine Änderung der Defektdichte in dem amorphen Halbleiter (4) zu ermöglichen.

3. Verfahren zur Behandlung nach einem der vorhergehenden Ansprüche, **dadurch gekennzeichnet, dass** die Äquilibrierungstemperatur ($T_E$) größer oder gleich 150 °C ist.

4. Verfahren nach einem der vorhergehenden Ansprüche, **dadurch gekennzeichnet, dass** die Äquilibrierungstemperatur ($T_E$) kleiner oder gleich einer maximalen Temperatur ist, oberhalb von welcher eine Schädigung des amorphen Halbleiters (4) erfolgen würde.

5. Verfahren nach einem der vorhergehenden Ansprüche, **dadurch gekennzeichnet, dass** die Äquilibrierungstemperatur ($T_E$) kleiner oder gleich 300 °C ist.

6. Verfahren nach einem der vorhergehenden Ansprüche, **dadurch gekennzeichnet, dass** während des Anlegens der elektrischen Zustandsänderungsspannung (U1) der Zellvorläufer (10) während einer Äquilibrierungsdauer ($\tau$) auf die Äquilibrierungstemperatur ($T_E$) erwärmt wird, wobei das Paar (T, ($\tau$) von Äquilibrierungstemperatur und -dauer in Abhängigkeit von einem gewünschten Wirkungsgrad gewählt wird, und dadurch, dass, um das Paar (T, ($\tau$) von Äquilibrierungstemperatur und -dauer zu bestimmen, in einer Phase der Vorkonfigurierung mehrere Test-Zellvorläufer bereitgestellt werden, die zu dem Vorläufer der herzustellenden Zelle analog sind, und für jeden Test-Vorläufer die Schritte des sandwichartigen Anordnens des Test-Vorläufers zwischen einem mit Masse verbundenen Träger und einer Platte aus Isoliermaterial, die mit einer leitfähigen Metallschicht bedeckt ist, des Anlegens einer elektrischen Zustandsänderungsspannung zwischen der Metallschicht und der Masse, bei gleichzeitigem Erwärmen des Test-Vorläufers auf eine Äquilibrierungstemperatur, und des Abkühlens des Test-Vorläufers vor dem Unterbrechen des Anlegens der elektrischen Zustandsänderungsspannung durchgeführt werden, wobei die verschiedenen Test-Vorläufer für verschiedene jeweilige Paare von Äquilibrierungstemperatur und -dauer getestet werden, und dass anschließend der Wirkungsgrad jedes Test-Vorläufers beurteilt wird und das optimale Paar von Äquilibrierungstemperatur und - dauer ausgewählt wird, das dem besten erhaltenen Wirkungsgrad entspricht.

7. Verfahren nach einem der vorhergehenden Ansprüche, **dadurch gekennzeichnet, dass** der Vorläufer (10) unter der elektrischen Zustandsänderungsspannung (U1) während einer Äquilibrierungsdauer ($\tau$) zwischen 1 und 30 Minuten auf die Äquilibrierungstemperatur ($T_E$) erwärmt wird.

8. Verfahren zur Behandlung nach einem der vorhergehenden Ansprüche, **dadurch gekennzeichnet, dass** die Anordnung, welche den Zellvorläufer (10), die leitfähige Platte (11) und die mit der leitfähigen Schicht (13) bedeckte Isolierstoffplatte (12) umfasst, in einem Raum (17) unter kontrollierter Atmosphäre angeordnet ist und zum Abkühlen des Vorläufers (10) ein Kühlfluid in dem Raum (17) zirkulieren gelassen wird.

9. Verfahren zur Behandlung nach einem der vorhergehenden Ansprüche, **dadurch gekennzeichnet, dass** die Isolierstoffplatte (12) eine Dicke größer oder gleich 100 nm aufweist.

10. Verfahren zur Herstellung einer Heteroübergangs-Photovoltaikzelle, **dadurch gekennzeichnet, dass** es umfasst:

    • einen Schritt (E0), der darin besteht, einen Zellvorläufer (10) bereitzustellen, der wenigstens eine Schicht aus dotiertem kristallinem Silicium (1) und eine Schicht aus dotiertem amorphem Halbleitermaterial (2, 4) aufweist, und
    • die Durchführung eines Verfahrens zur Behandlung nach einem der Ansprüche 1 bis 9, angewendet auf diesen Zellvorläufer.

11. Verfahren zur Herstellung nach dem vorhergehenden Anspruch, **dadurch gekennzeichnet, dass**, nach Abkühlung des Zellvorläufers (10) und Unterbrechung der elektrischen Zustandsänderungsspannung (U1), das Verfahren zur Herstellung einen Schritt (E8) des Aufbringens wenigstens einer Schicht aus elektrisch leitfähigem Material und einen Schritt der Metallisierung (E9) zum Ausbilden von elektrischen Kontakten umfasst.

12. Einrichtung zur Behandlung eines Vorläufers einer Heteroübergangs-Photovoltaikzelle (100), die insbesondere im Verlauf der Herstellung der Zelle eingesetzt wird, **dadurch gekennzeichnet, dass** sie umfasst:

    • eine mit Masse verbundene leitfähige Platte (11) ;
    • eine Platte (12) aus Isoliermaterial, die mit einer leitfähigen Schicht (13) bedeckt ist, wobei die zwei Platten (11, 12) dafür ausgelegt sind, einen zu behandelnden Vorläufer einer Photovoltaikzelle sandwichartig einzuschließen, wobei der Vorläufer wenigstens eine Schicht aus dotiertem kristallinem Silicium und eine Schicht aus dotiertem amorphem Halbleitermaterial aufweist;
    • einen elektrischen Spannungsgenerator (16), der mit der leitfähigen Schicht (13) verbunden ist;
    • eine Heizvorrichtung (110, 15);
    • eine Kühlvorrichtung (17);
    • ein Steuermodul, das dazu bestimmt ist, den Betrieb des elektrischen Spannungsgenerators (16), der Heizvorrichtung (110, 15) und der Kühlvorrichtung (17) derart zu steuern, dass eine elektrische Zustandsänderungsspannung (U1) zwischen der leitfähigen Schicht (13) und der Masse angelegt wird, wobei die elektrische Zustandsänderungsspannung geeignet ist, die Fermi-Energie an der Grenzfläche (INT) zwischen kristallinem Silicium und amorphem Halbleitermaterial an die Mitte der Bandlücke des amorphen Halbleitermaterials anzunähern, bei gleichzeitigem Erwärmen des Zellvorläufers auf eine Äquilibrierungstemperatur von Defekten ($T_E$), und anschließend der Vorläufer abgekühlt wird, bevor das Anlegen der elektrischen Zustandsänderungsspannung (U1) unterbrochen wird.

**Claims**

1. A method for processing a precursor of a heterojunction photovoltaic cell (100), the precursor comprising at least one layer of doped crystalline silicon (1) and a layer of doped amorphous semiconductor material (2, 4), **characterized in that** it comprises the following steps:

    • place the cell precursor (10) sandwiched between a grounded conducting plate (11) and a plate made of insulating material (12) coated with a conducting layer (13);
    • apply a state change electrical voltage (U1) between the conducting layer (13) and ground, the said state change electrical voltage (U1) being designed to bring the Fermi level at the interface (INT) between crystalline silicon (1) and amorphous semiconductor material (4) closer to the middle of the band gap of the said amorphous semiconductor material (4), while at the same time heating the cell precursor (10) to a defect equilibration temperature ($T_E$);
• cool down the cell precursor (10) prior to interrupting the application of the state change electrical voltage (U1).

2. The processing method as claimed in claim 1, **characterized in that** the equilibration temperature ($T_E$) is higher than or equal to a defect equilibration threshold temperature ($T_{TSH}$) below which the energy provided is insufficient to allow a modification of the defect density in the amorphous semiconductor (4).

3. The processing method as claimed in one of the preceding claims, **characterized in that** the equilibration temperature ($T_E$) is higher than or equal to 150°C.

4. The method as claimed in one of the preceding claims, **characterized in that** the equilibration temperature ($T_E$) is less than or equal to a maximum temperature beyond which the amorphous semiconductor (4) would be degraded.

5. The method as claimed in one of the preceding claims, **characterized in that** the equilibration temperature ($T_E$) is less than or equal to 300°C.

6. The method as claimed in one of the preceding claims, **characterized in that**, during the application of the state change electrical voltage (U1), the cell precursor (10) is heated to the equilibration temperature ($T_E$) for an equilibration time ($\tau$), the temperature and equilibration time pair ($T,\tau$) being chosen as a function of a desired efficiency, and **in that**, in order to determine the temperature and equilibration time pair ($T,\tau$), during a prior configuration phase, a plurality of test cell precursors, analogous to the precursor of the cell to be fabricated, is provided and, for each test precursor, the steps are implemented for placing the said test precursor sandwiched between a grounded support and a plate made of insulating material coated with a conducting metal layer, for applying a state change electrical voltage between the conducting metal layer and ground, while at the same time heating the test precursor to an equilibration temperature, and for cooling down the test precursor prior to interrupting the application of the state change electrical voltage, the various test precursors being tested for various respective pairs of temperature and of equilibration time, then the efficiency of each test precursor is evaluated and the optimum pair of temperature and of equilibration time is selected corresponding to the best efficiency obtained.

7. The method as claimed in one of the claims, **characterized in that** the precursor (10) is heated to the equilibration temperature ($T_E$) with the application of the state change electrical voltage (U1) for an equilibration time ($\tau$) in the range between 1 and 30 minutes.

8. The processing method as claimed in one of the preceding claims, **characterized in that** the assembly comprising the cell precursor (10), the conducting plate (11) and the insulating plate (12) coated with the conducting layer (13) is placed in a vessel (17) under a controlled atmosphere and, in order to cool down the precursor (10), a cooling fluid is circulated within the vessel (17).

9. The processing method as claimed in one of the preceding claims, **characterized in that** the insulating plate (12) has a thickness greater than or equal to 100 nm.

10. A method of fabrication of a heterojunction photovoltaic cell, **characterized in that** it comprises:

   • a step (E0) consisting in providing a cell precursor (10) comprising at least one layer of doped crystalline silicon (1) and one layer of doped amorphous semiconductor material (2, 4) and
   • the implementation of a processing method as claimed in one of claims 1 to 9, applied to said cell precursor.

11. The method of fabrication as claimed in the preceding claim, **characterized in that**, after cooling down the cell precursor (10) and interruption of the state change electrical voltage (U1), the method of fabrication comprises a step (E8) for deposition of at least one layer of electrically-conducting material and a metallization step (E9) in order to form electrical contacts.

12. A piece of equipment for processing a precursor of a heterojunction photovoltaic cell (100), notably implemented during the fabrication of the cell, **characterized in that** it comprises

   • a grounded conducting plate (11);
   • a plate (12) made of an insulating material coated with a conducting layer (13), the two plates (11, 12) being arranged to sandwich a photovoltaic cell precursor to be processed, the said precursor comprising at least one layer of doped crystalline silicon and one layer of doped amorphous semiconductor material;

• an electrical voltage generator (16) connected to the said conducting layer (13);
• a heating device (110, 15);
• a cooling device (17);
• a control module designed to control the operation of the electrical voltage generator (16), of the heating device (110, 15) and of the cooling device (17) in such a manner as to apply a state change electrical voltage (U1) between the conducting layer (13) and ground, the said state change electrical voltage being designed to bring the Fermi level at the interface (INT) between crystalline silicon and amorphous semiconductor material closer to the middle of the band gap of the said amorphous semiconductor material, while at the same time heating the cell precursor to a defect equilibration temperature ($T_E$), then to cool down the precursor prior to interrupting the application of the said state change electrical voltage (U1).

**Figure 1**

**Figure 2**

**Figure 3**

**Figure 4**

**Figure 5**

Position du niveau de Fermi
$E_F - E_v$ (eV)

**Figure 6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013001440 A

**Littérature non-brevet citée dans la description**

- **M. J. POWELL ; S. C. DEANE.** Defect-pool model and the hydrogen density of states in hydrogenated amorphous silicon. *Phys. Rev. B,* 1996, vol. 53, 10121-32